# EUROPEAN PATENT APPLICATION

(11) **EP 4 418 302 A1**
(43) Date of publication of application: **21.08.2024**
(21) Application number: 23156956.7
(22) Date of filing: 16.02.2023
(51) Int. Cl.: H01J 37/04, H01J 37/24, H01J 37/244

(54) **CHARGED PARTICLE-OPTICAL ELEMENT, CHARGED PARTICLE-OPTICAL MODULE, ASSESSMENT APPARATUS, CHIP ASSEMBLY, METHOD OF MANUFACTURING**

(71) Applicant: ASML Netherlands B.V., 5500 AH Veldhoven (NL)
(72) Inventor: RODRIGUES MANSANO, Andre, Luis, 5500 AH Veldhoven (NL); WIELAND, Marco, Jan-Jaco, 5500 AH Veldhoven (NL); DEL TIN, Laura, 5500 AH Veldhoven (NL); SLOT, Erwin, 5500 AH Veldhoven (NL); MA, Yue, 5500 AH Veldhoven (NL); VAN DEN BROM, Alrik, 5500 AH Veldhoven (NL)
(74) Representative: ASML Netherlands B.V.

(57) **Abstract**

A charged particle-optical element is disclosed. The element is for a charged particle-optical module configured to direct charged particles along at least one beam path towards a sample. In one arrangement, the element comprises a chip comprising an integrated circuit 64 formed in a semiconductor substrate 61. The substrate defines at least one aperture 63 for passage therethrough of the at least one beam path. A size of the substrate exceeds a die-size of a lithographic imaging system used during manufacturing of the integrated circuit.

## Description

### FIELD

The embodiments provided herein generally relate to apparatus for directing charged particles such as electrons towards a sample and related apparatus and methods.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection tools with a charged particle beam have been used to assess objects, for example to detect pattern defects. These tools typically use electron microscopy techniques, such as a scanning electron microscope (SEM). In a SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incident charged particles. As an area of the sample is inspected, the signals comprise data which is processed to generate the inspection image corresponding to the inspected area of the sample.

Charged particle-optical elements (e.g., electron-optical elements) may be used to manipulate beams of charged particles and/or to detect the signal particles. Such elements may require relatively high powers and/or be located in positions where space is limited. Charged particles may additionally impinge on such elements or on structures that are in thermal contact with such elements, contributing heating. It can be difficult to control the temperature of charged-particle elements and/or the need to control temperature may impose functional limitations on the elements, such as limiting the performance of the elements. Integrated circuits may be used to perform complex functions in charged particle-optical elements. Integrated circuits generate heat and are typically required to operate without exceeding a maximum recommended operation temperature.

### SUMMARY

It is an object of the present disclosure to at least partially address one or more of the challenges discussed above, including for example to improve thermal management in charged particle-optical elements.

According to an aspect of the invention, there is provided a charged particle-optical element for a charged particle-optical module configured to direct charged particles along at least one beam path towards a sample, the charged particle-optical element comprising: a chip comprising an integrated circuit formed in a semiconductor substrate, the substrate defining at least one aperture for passage therethrough of the at least one beam path, wherein: a size of the substrate exceeds a die-size of a lithographic imaging system used during manufacturing of the integrated circuit.

Configuring the substrate to have a size exceeding the die-size may facilitate temperature control by providing additional space for cooling arrangements and/or allowing heat sources to be positioned further from a beam area. The increased size may additionally or alternatively provide design freedom for improving mechanical support of the substrate. The improved mechanical support may contribute to effective temperature control, for example by providing low thermal resistance paths for heat to be conducted efficiently away from the substrate.

In an embodiment, the substrate comprises an inner region and a peripheral region; the integrated circuit is formed within the inner region; the peripheral region is free of any functional integrated circuit; and the peripheral region is laterally outside of the inner region when viewed perpendicularly to a major surface of the substrate. In an embodiment, a cooling element is mounted to the peripheral region and configured to extract heat from the substrate. The increased space provided by arranging for the size of the substrate to exceed the die-size facilitates configuring the cooling element to have high performance. The peripheral region provides a relatively large contact area for the cooling element, which may promote improved cooling performance. The increased space may allow the cooling element to be larger and/or facilitate provision of effective internal channels for heat-exchange fluid.

In an embodiment, a contact area between the cooling element and the substrate is greater than 10% of the die-size of a lithographic imaging system used during manufacturing of the integrated circuit. Providing a large contact area may improve cooling performance.

In an embodiment, a mechanical support element is configured to mechanically support the substrate, wherein the mechanical support element is configured to support the substrate via the peripheral region of the substrate. The increased space provided by arranging for the size of the substrate to exceed the die-size facilitates configuring the mechanical support element to have high performance. The mechanical support element can, for example, contact the substrate over a larger area, thereby spreading forces applied to the substrate and reducing potentially damaging pressures and/or torques. Additionally, a large contact area may allow the mechanical support element to contribute to improving cooling of the substrate by providing a high thermal conductance path for heat to flow away from the substrate.

According to an aspect of the invention, there is provided a chip assembly comprising: a chip comprising an integrated circuit formed in a semiconductor substrate, wherein a size of the substrate exceeds a die-size of a lithographic imaging system used during manufacturing of the integrated circuit; and a cooling element mounted to a peripheral region laterally outside of an inner region in which the integrated circuit is formed, wherein the cooling element comprises a heat sink body defining one or more internal channels for directing flow of a heat-exchange fluid through the body.

According to an aspect of the invention, there is provided a method of manufacturing a charged particle-optical element, comprising: manufacturing an integrated circuit within a die of a semiconductor wafer, a die-size of the die being defined by a lithographic imaging system used during the manufacturing of the integrated circuit; cutting a chip out of the wafer, wherein the chip comprises the integrated circuit formed in a substrate derived from the wafer; forming at least one aperture in the substrate for passage through the substrate of at least one beam path of a charged particle beam, wherein: a size of the substrate exceeds the die-size of the lithographic imaging system.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary assessment apparatus.
Figure 2 is a schematic diagram illustrating an exemplary multi-beam charged particle-optical device that is part of the exemplary assessment apparatus of Figure 1.
Figure 3 is a schematic diagram of an exemplary charged particle-optical device comprising a collimator element array and a scan-deflector array that is part of the exemplary assessment apparatus of Figure 1.
Figure 4 is a schematic diagram of an exemplary charged particle-optical device array comprising the charged particle-optical devices of Figure 3.
Figure 5 is a schematic diagram of an alternative exemplary charged particle-optical device that is part of the exemplary assessment apparatus of Figure 1.
Figure 6 is a schematic diagram of an exemplary charged particle-optical module that may be part of the charged particle-optical devices of Figures 3, 4 and 5.
Figure 7 is a schematic diagram of an exemplary charged particle-optical element.
Figure 8 is a schematic diagram of an exemplary charged particle-optical element.
Figure 9 is a schematic plan view of a charged particle-optical element of the type depicted in Figure 8.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

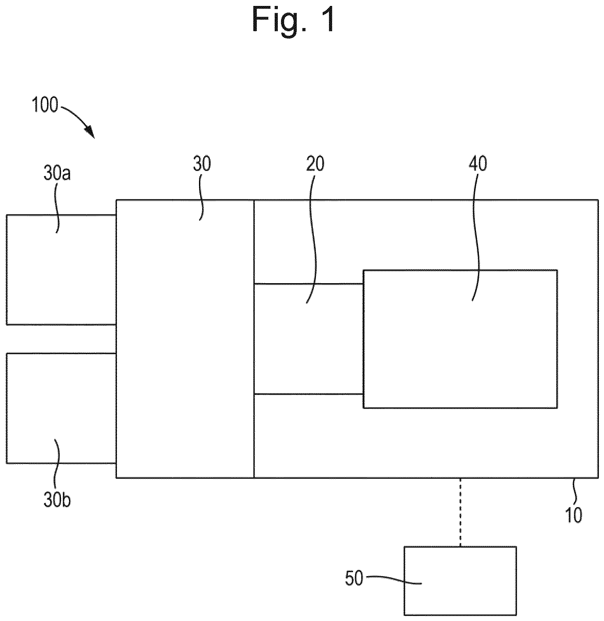

Reference is now made to Figure 1, which is a schematic diagram illustrating an exemplary assessment apparatus 100, or inspection apparatus. The assessment apparatus 100 of Figure 1 includes a vacuum chamber 10, a load lock chamber 20, an charged particle-optical apparatus, an equipment front end module (EFEM) 30 and a controller 50. The charged particle-optical device 40 may be within the vacuum chamber 10. The electron-optical apparatus may comprise an charged particle-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. An charged particle-optical device 40 may comprise either a single beam or a multi-beam charged particle-optical apparatus.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing an charged particle-optical device. Rather, it is appreciated that the foregoing principles may also be applied to other apparatuses and other arrangements of apparatus that operate under the second pressure.

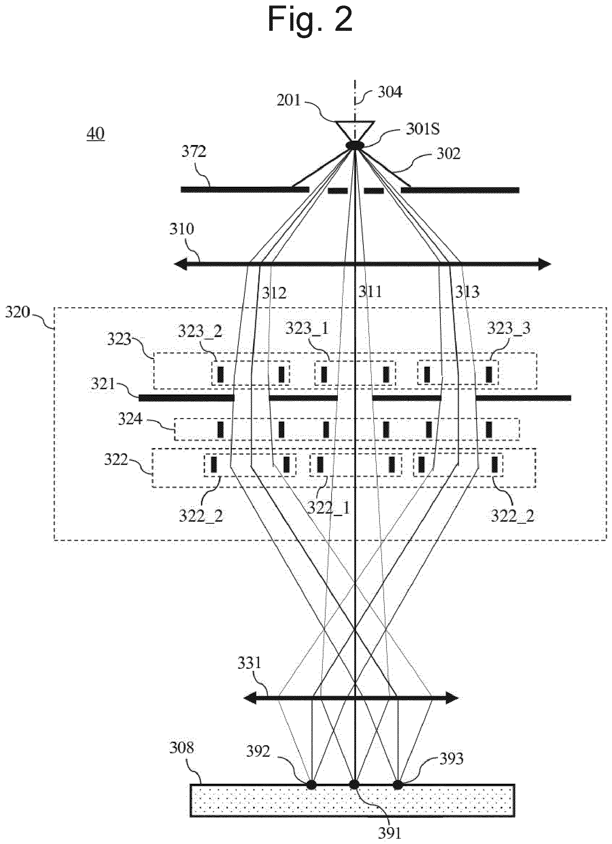

Reference is now made to Figure 2, which is a schematic diagram of an exemplary multi-beam charged particle-optical device 40 of an assessment apparatus, e.g. the assessment apparatus 100 of Figure 1. In an alternative embodiment the assessment apparatus 100 is a single-beam assessment apparatus. The charged particle-optical device 40 may comprise an electron source 201, a beam former array 372 (also known as a gun aperture plate, a coulomb aperture array or a pre-sub-beamforming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incident electrons. The electron source 201, the beam former array 372, the condenser lens 310 may be the components of an illumination apparatus comprised by the charged particle-optical device 40. The source converter 320 (also known as a source conversion unit), described in more detail below, and the objective lens 331 may be the components of a projection apparatus comprised by the charged particle-optical device 40.

The electron source 201, the beam former array 372, the condenser lens 310, the source converter 320, and the objective lens 331 are aligned with a primary electron-optical axis 304 of the charged particle-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an charged particle-optical device 40 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the charged particle-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the charged particle-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The charged particle-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The charged particle-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. The one or more electron-optical components in the charged particle-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the charged particle-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

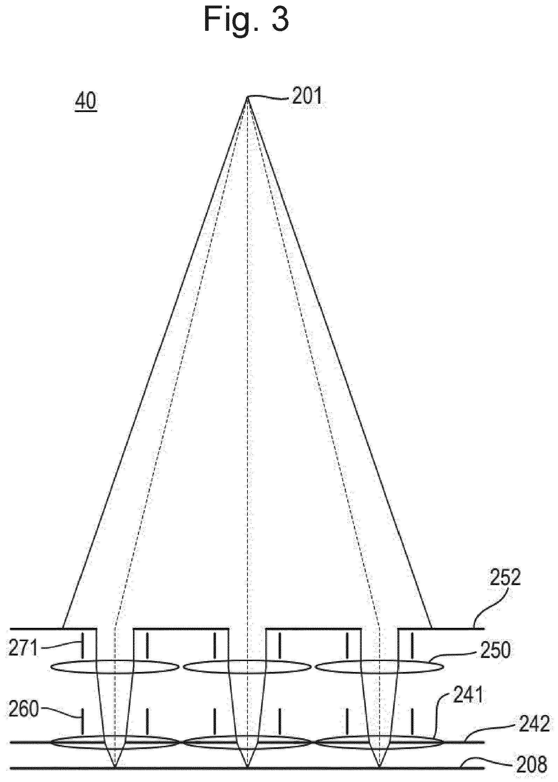

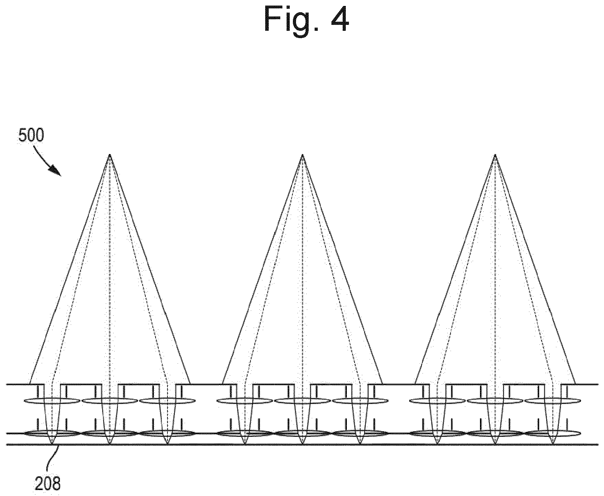

In an embodiment the charged particle-optical device 40 may comprise alternative and/or additional components on the charged particle path, such as lenses and other components some of which have been described earlier with reference to Figures 1 and 2. Examples of such arrangements are shown in Figures 3 and 4 which are described in further detail later. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

Figure 3 is a schematic diagram of another design of an exemplary charged particle-optical device 40. The charged particle-optical device 40 may comprise a source 201 and one or more electron-optical assemblies. Alternatively, the electron-optical apparatus that comprises the charged particle-optical device 40 may comprise the source 201. The charged particle-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons).

The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided downbeam of the upper beam limiter 252. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path downbeam of the source 201. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit).

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. In an embodiment, the scanning deflectors described in EP2425444, which document is hereby incorporated by reference in its entirety specifically in relation to scan deflectors, may be used to implement the scan-deflector array 260.

The objective lens array 241 comprising a plurality of objective lenses is provided to direct the sub-beams onto the sample 208. Each objective lens comprises at least two electrodes (e.g. two or three electrodes) connected to respective potential sources.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241.

In an embodiment, the charged particle-optical device 40 is configured to control the objective lens array assembly (e.g. by controlling potentials applied to electrodes of the control lens array 250) so that a focal length of the control lenses is larger than a separation between the control lens array 250 and the objective lens array 241.

An electric power source may be provided to apply respective potentials to electrodes of the control lenses of the control lens array 250 and the objective lenses of the objective lens array 241.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the charged particle-optical device facing the sample 208, e.g. the bottom surface of the charged particle-optical device. Alternative the detector array be upbeam of the bottom surface or example in or upbeam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, a charged particle-optical device array 500 is provided. The array 500 may comprise a plurality of any of the charged particle-optical devices described herein. Each of the charged particle-optical devices focuses respective multi-beams simultaneously onto different regions of the same sample.

Any number of charged particle-optical devices may be used in the array 500. Each charged particle-optical device in the array 500 may be configured in any of the ways described herein when referring to a single charged particle-optical device, for example as described above, especially with respect to the embodiment shown and described in reference to Figure 3. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of charged particle-optical devices of the type described above with reference to Figure 3.

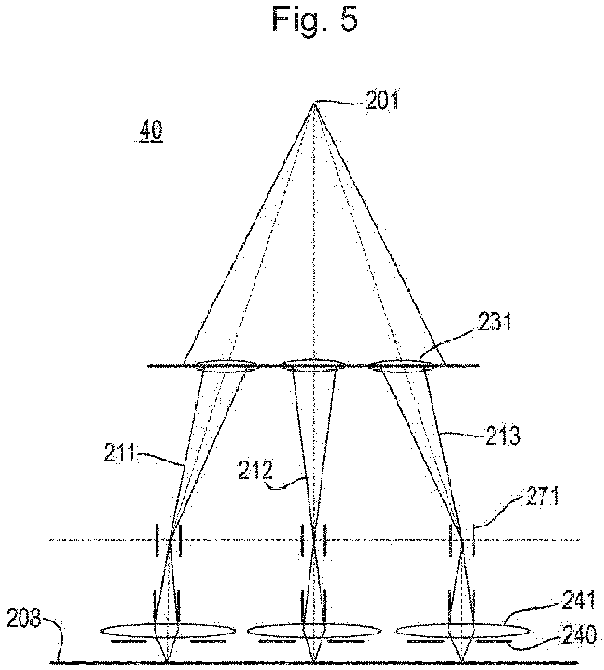

An alternative design of multi-beam charged particle-optical device may have the same features as described with respect to Figure 3 except as described below and illustrated in Figure 5. The alternative design of multi-beam charged particle-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components.

In an embodiment of the arrangement shown in and described with reference to Figure 5, the detector may be located in similar locations in the charged particle-optical device 40 as described with reference to and as shown in the charged particle-optical device of Figure 3. The detector 240 may be integrated into the objective lens array 241 and the control lens array 250 (when present as it is not depicted in Figure 5). The detector may have more than one detector at different positions along the paths of the sub-beams of the multibeam.

An charged particle-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus. A further alternative design of multi-beam apparatus comprises multiple single beam devices.

The charged particle-optical device 40 may be a component of an assessment apparatus (e.g. for inspection, metrology, metro-inspection or any other type of assessment) or part of an e-beam lithography apparatus or other type of charged particle induced sample patterning apparatus. The multi-beam charged particle apparatus may be used in a number of different applications that include electron microscopy in general, not just scanning electron microscopy, and lithography.

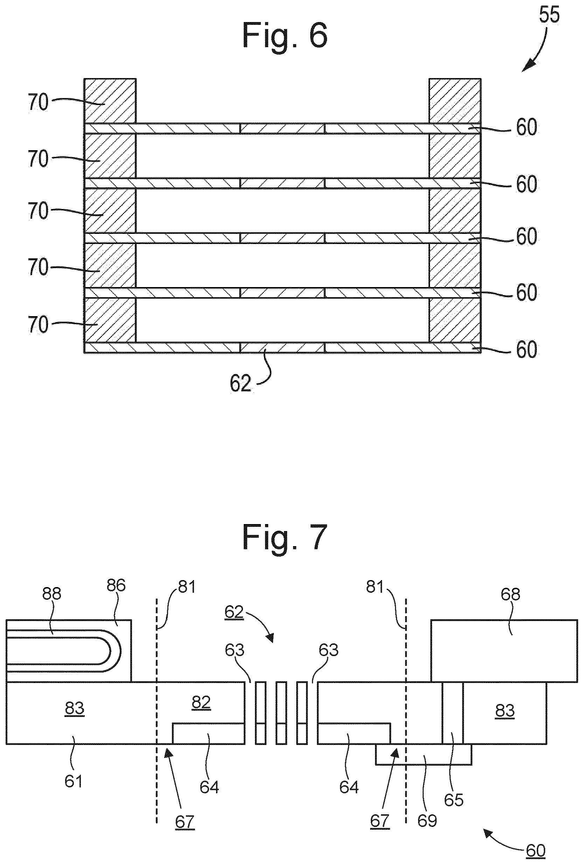

The charged particle-optical device 40 may comprise an charged particle-optical module 55 as shown in Figure 6 for manipulating electron beamlets. For example, the charged particle-optical module 55 may comprise one or more of (in a non-limited list): the objective lens array 241 and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the charged particle-optical module 55. The charged particle-optical module 55 is configured to provide a potential difference between two or more plates (or substrates).

Figure 6 schematically depicts a charged particle-optical module 55. The charged particle-optical module 55 is configured to direct electrons along at least one beam path towards a sample location. In the orientation shown in Figure 6, the at least one beam path extends vertically from top to bottom through the middle of the charged particle-optical module 55. There may be one beam path corresponding to one electron beam. Alternatively, there may be a plurality of beam paths corresponding to a plurality of charged particle sub-beams of a multi-beam.

As shown in Figure 6, in an embodiment the charged particle-optical module 55 comprises a plurality of planar elements arranged across the beam path. In an embodiment one or more of the planar elements is a charged particle-optical element 60. The charged particle-optical element 60 is configured to operate on the one or more charged particle beams. As shown in Figure 6, in an embodiment all of the planar elements are charged particle-optical elements 60. Alternatively, one or more of the planar elements may be a planar element other than an charged particle-optical element. For example, one or more of the planar elements may be an element that is not required to have a voltage applied for it to perform its function, or the planar element is required to have a voltage applied to it so there is substantially zero potential difference between the element and an adjoining element along the beam path. One example is a planar element that is a beam limiting aperture array comprising apertures dimensioned to shape the charged particle beams. For example, the apertures may allow charged particle beams of a particular shape to pass through, while blocking charged particles that are outside of those beams. As a further alternative, a planar element configured to shape the charged particle beams may also have a potential difference with respect to an upbeam and/or downbeam planar element such that the electromagnetic field affects the charged particle beams in addition to the beam shaping function.

As shown in Figure 6, in an embodiment the charged particle-optical module 55 comprises one or more spacers 70. The spacers 70 are configured to mechanically support the planar elements. As shown in Figure 6, in an embodiment a spacer 70 is configured to mechanically separate planar elements such as charged particle-optical elements 60 from each other. In an embodiment the spacers 70 are configured to electrically isolate planar elements such as charged particle-optical elements 60 from each other. However, it is not essential for the spacers 70 to provide electrical isolation. For example, it may be that two adjacent charged particle-optical elements 60 are arranged to be operated at the same voltage (i.e. having no potential difference between them), in which case electrical isolation may not be required. In an embodiment one or more pairs of adjacent planar elements are adjoined to each other, i.e. without an intermediate spacer 70. The spacers 70 are optional features.

The charged particle beams are configured to pass through the beam area 62 of the charged particle-optical module 55. As shown in Figure 6, the beam area 62 may be in a central portion of the charged particle-optical module 55. The beam area 62 is located generally centrally when viewed in a direction parallel to the at least one beam path. The beam area 62 is located centrally when viewed in a direction orthogonal to the plane of the planar elements.

In an embodiment the charged particle-optical module 55 is comprised in a charged particle-optical device 40, for example a charged particle-optical device 40 as shown in and described with reference to Figure 2, Figure 3 and/or Figure 5. In an embodiment the charged particle-optical module 55 is field replaceable. The charged particle-optical module 55 may be removed from and/or inserted into the charged particle-optical device 40 without requiring any substantial dismantling of other parts of the charged particle-optical device 40. That is the charged particle-optical module 55 may be removable from and/or insertable into the charged particle-optical device 40.

In an embodiment the charged particle-optical module 55 comprises an objective lens assembly comprising the objective lens array 241. The charged particle-optical module 55 may further comprise a control lens array 250, a detector 240 and/or a deflector array. In an alternative embodiment, the charged particle-optical module 55 may be a condenser lens assembly. The charged particle-optical module 55 may comprise a condenser lens array 231. The charged particle-optical module 55 may further comprise one or more of a deflector array and/or a beam limiting aperture array.

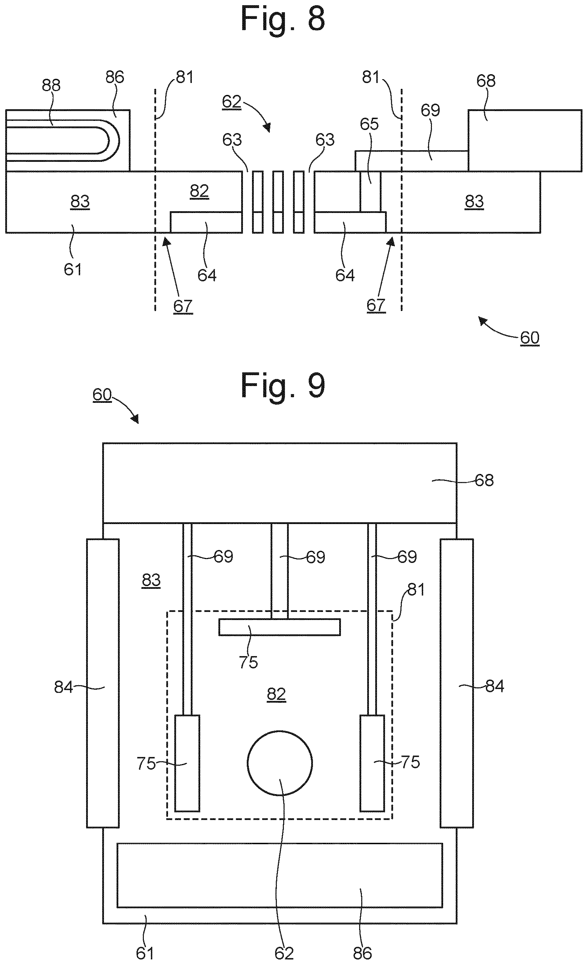

Figures 7 and 8 are schematic side sectional views of exemplary charged particle-optical elements 60. Figure 9 is a schematic plan view of an element 60 of the type depicted in Figure 8. Relative dimensions and/or aspect ratios in Figures 7-9 are exaggerated for clarity of depiction. The element 60 may be configured to be suitable for incorporation into a charged particle-optical module 55 such as the charged particle-optical module 55 shown in Figure 6. The charged particle-optical module 55 is configured to direct charged particles along at least one beam path towards a sample 208.

In an embodiment, the charged particle-optical element 60 comprises a chip. The chip comprises an integrated circuit 64. The integrated circuit 64 is formed in a semiconductor substrate 61. The substrate 61 comprises or consists of a semiconducting material such as silicon. The chip is formed by cutting the substrate 61 from a larger substrate such as a silicon wafer after the integrated circuit has been formed using a lithographic manufacturing process. The lithographic manufacturing process uses a lithographic imaging system to define patterns to be formed in one or more layers of the integrated circuit. The substrate 61 may be substantially planar.

In an embodiment the integrated circuit 64 comprises a plurality of layers. The layers may define one or more layers of circuitry. The layers may, for example, define complementary metal oxide semiconductor (CMOS) circuitry. The integrated circuit 64 may thus comprise CMOS elements. In an embodiment, the CMOS circuitry comprises a metal layer or multiple metal layers. In an embodiment, the integrated circuit is configured to detect signal particles emitted from the sample. The metal layer may, for example, comprise one or more electrodes which may provide a surface of the CMOS circuitry on the substrate 61 which in operation may face a sample 208. The metal layer may comprise detector elements configured to detect the signal particles. The detector elements may be referred to as capture electrodes. Capture electrodes are examples of sensor units for detecting signal particles. Power and control signals of the CMOS circuitry may be connected to the CMOS circuitry by electrical connections running to the integrated circuit 64 from a region outside of the integrated circuit 64. The CMOS circuitry may comprise a logic layer. The logic layer may be in a different layer to the one or more electrodes. The logic layer may include amplifiers such as trans impedance amplifiers (TIAs), filters, analog-to-digital converters (ADCs) and/or readout logic. In other embodiments, the integrated circuit may be formed using SiGe or GaAs technology. The integrated circuit may thus alternatively or additionally comprise SiGe circuitry or GaAs circuitry.

In an embodiment, as exemplified in Figures 7 and 8, the substrate 61 comprises (e.g., defines) at least one aperture 63. The or each aperture 63 passes through the chip 61. The or each aperture 63 is configured to allow passage therethrough of at least one beam path. Each aperture 63 thus provides a route for at least one beam of charged particles to pass through the substrate 61. In the examples of Figures 7 and 8, the substrate 61 comprises a plurality of apertures 63. Each aperture 63 may allow one charged particle beam or a group of charged particle beams to pass through the aperture 63. Figures 7 and 8 schematically show four apertures 63. The number of apertures 63 may be much greater than four. As indicated in Figures 7 and 8, the apertures 63 are provided in the beam area 62 of the charged particle-optical element 60. In an alternative embodiment there may be only one aperture 63. For example, a charged particle-optical device 40 that comprises the charged particle-optical element 60 may be configured to direct a single charged particle beam towards a sample 208. Alternatively, the single aperture 63 may be for the passage therethrough of a plurality of sub-beams of a multi-beam (or beam grid). The charged particle-optical element 60 having the single aperture 63 may in this case be a macro element configured to operate on all of the sub-beams of the multi-beam.

As shown in Figures 7 and 8, in an embodiment the integrated circuit 64 is located adjacent to one or more of the apertures 63. In an embodiment, the integrated circuit 64 surrounds each of one or more of the apertures 63. In an embodiment, the integrated circuit 64 defines one or more electrodes at each aperture 63. In an embodiment, the integrated circuit 64 may comprise one or more electrodes that define one or more of the apertures 63. The electrodes may operate on charged particle beams passing through the apertures 63.

In an embodiment, the integrated circuit comprises and/or controls one or more deflectors. Each deflector may be configured to operate on a charged particle beam (or group of charged particle beams) passing through a respective aperture 63. The deflector may be configured to control a direction of the charged particle beam downbeam of the charged particle-optical element 60. For example, the deflector may be configured to control where the charged particle beam is incident on a downbeam charged particle-optical element 60 or on the sample 208. The deflector may be configured to control whether one or more charged particle beams passes through apertures of a downbeam planar element or whether the one or more charged particle beams are blocked by the downbeam planar element.

In an embodiment the integrated circuit 64 comprises and/or controls a multipole. A multipole may comprise a plurality of electrodes for a respective aperture 63. The multipole may be configured to correct one or more parameters of the charged particle beam passing through the aperture 63. For example, in an embodiment the multipole may be a stigmator configured to moderate a shape of a charged particle beam passing through the aperture 63.

In an embodiment the integrated circuit 64 comprises and/or controls one or more aberration compensators or correctors. The aberration compensators may be formed into an aberration compensator array. In an embodiment the aberration compensator may be configured to operate on an individual aperture 63. For example, the aberration compensator may be configured to control the field curvature and/or astigmatism of the charged particle beams.

As mentioned in the introductory part of the description, charged particle-optical elements 60 may be subjected to significant heating during use. Heating may occur particularly in and/or near the beam area 62. Heating sources include the charged particle beams and active electronics such as the integrated circuit 64. Embodiments of the present disclosure facilitate temperature control by configuring the substrate 61 to have a size (e.g., defined by an area of a major surface thereof) that exceeds a die-size (e.g., a processable area) of a lithographic imaging system used during manufacturing of the integrated circuit 64. The substrate 61 is thus significantly larger laterally than would usually be the case for a substrate 61 containing an integrated circuit 64. The substrate 61 may be described as being laterally extended. Laterally extending the substrate 61 provides additional space in a peripheral region. The additional space can be exploited to improve temperature control of the substrate 61. The additional space may be used to provide more effective cooling arrangements and/or to position other heat sources further away from the beam area 62. Alternatively or additionally, the increase in size may provide design freedom for improving mechanical support of the substrate 61. The improved mechanical support may be configured to contribute to temperature control of the substrate 61, for example by providing low thermal resistance paths for heat to be conducted efficiently away from the substrate 61.

In an embodiment, the size of the substrate 61 is larger than a maximum die-size of the lithographic imaging system. The maximum die-size is the largest die area that the lithographic imaging system can process. The die-size of the lithographic imaging system may be referred to as the field size of the lithographic imaging system. In an embodiment, the substrate 61 is at least 1.5 times larger, at least 2 times larger, at least 3 times larger, at least 4 times larger, or at least 5 times larger, than the maximum die-size of the lithographic imaging system. As a result of being larger than the die-size, the substrate 61 may comprise one or more scribe lane structures 67, such as scribe lane alignment marks. The one or more scribe lane structures 67 may be formed in a scribe lane located outside of the integrated circuit 64 when viewed perpendicularly to a major surface of the substrate 61. In an embodiment, the one or more scribe lane structures 67 are located between the integrated circuit 64 and at least a portion of a peripheral region 83 when viewed perpendicularly to the major surface of the substrate 61. Such scribe lane structures 67 would not normally be present in a chip after the chip has been cut from a larger semiconductor substrate (e.g., silicon wafer) after formation of the integrated circuit 64 by the lithographic manufacturing process. The presence of the scribe lane structures 67 thus indicates that the size of the substrate 61 is larger than a die-size of the lithographic imaging system using during manufacturing of the integrated circuit 64.

A method of manufacturing a charged particle-optical element 60 may therefore be provided. The method comprises manufacturing an integrated circuit 64 within a die of a semiconductor wafer. A die-size of the die is defined by the lithographic imaging system, for example by a field size of the lithographic imaging system. Any of various known types of lithographic imaging system may be used. The integrated circuit 64 may take any of the forms described above. The method further comprises cutting a chip out of the wafer. The chip comprises the integrated circuit 64 in a substrate 61 derived from the wafer. The method comprises forming at least one aperture 63 in the substrate 61. The at least one aperture 63 may be formed by etching for example. The at least one aperture 63 may take any of the forms described above. The at least one aperture 63 is configured to allow passage through the substrate 61 of at least one beam path of a charged particle beam. The method is configured such that a size of the substrate 61 exceeds the die-size of the lithographic imaging system.

In an embodiment, the substrate 61 comprises an inner region 82 and a peripheral region 83. The integrated circuit 64 is formed within the inner region 82. The peripheral region 83 is free of any functional integrated circuit. No portion of a functional integrated circuit is thus formed in the peripheral region 83. The peripheral region 83 is laterally outside of the inner region 82 when viewed perpendicularly to a major surface of the substrate 61 (e.g., to a largest surface of the substrate 61, such as the top or bottom surface). The peripheral region 83 may extend to an outer boundary or edge of the substrate 61. The peripheral region 83 may surround the inner region 82 when viewed perpendicularly to the major surface of the substrate 61. The peripheral region 83 is integrally connected to the inner region 82. The material of the substrate 61 thus extends continuously from the inner region 82 to the peripheral region 83 without any interface or structural mismatch separating the inner region 82 from the peripheral region 83. The inner region 82 and the peripheral region 83 may, for example, originate from the same silicon wafer and represent a single, contiguous portion of the silicon wafer. In an embodiment, an inner boundary 81 of the peripheral region 83 defines a region (when viewed perpendicularly to a plane of the substrate 61) that is equal in size (e.g., surface area) to the die-size of the lithographic imaging system used during manufacturing of the integrated circuit. The inner boundary 81 is depicted by broken lines in Figure 7-9.

In an embodiment, the element 60 is configured to provide a plurality of electrically conductive paths from the peripheral region 83 to the integrated circuit 64. The conductive paths may comprise one or more of the following: one or more redistribution layers; and one or more through substrate vias, TSVs. The electrically conductive paths allow elements positioned laterally outside of the inner region 82 to be electrically connected to the integrated circuit 64.

In an embodiment, as depicted in Figures 7-9, at least a subset of the conductive paths connect the integrated circuit 64 to an electronics unit 68. The electronics unit 68 may comprise a printed circuit board (PCB). In an embodiment, the electronics unit 68 is located on an opposite side of the substrate 61 to the integrated circuit 64. As depicted in Figures 7 and 8, in some embodiments the electronics unit 68 is provided on an upbeam side of the substrate 61 (above the substrate 61 in the orientation shown) and the integrated circuit 64 is provided at a downbeam side of the substrate 61 (below the substrate 61 in the orientation shown). In an alternative embodiment, the electronics unit 68 is provided at the downbeam side of the substrate 61.

In an embodiment, the electronics unit 68 (e.g., PCB) is secured to the substrate 61. The electronics unit 68 may be bonded to the substrate 61. The electronics unit 68 may be secured to a major surface of the substrate 61. The electronics unit 68 may overlap a portion of the major surface of the substrate 61. As shown in Figures 7 and 8, in an embodiment the electronics unit 68 extends laterally beyond a peripheral outer edge of the substrate 61. In an embodiment the electronics unit 68 is configured to transfer power to the integrated circuit 64. For example, the electronics unit 68 may be electrically connected to a power supply configured to supply electrical power to the integrated circuit 64. Additionally or alternatively, the electronics unit 68 may be configured to transfer signals to the integrated circuit 64. For example, in an embodiment the electronics unit 68 is configured to supply control signals to the integrated circuit 64. The control signals may be, for example, control signals for controlling the gain and/or offset of analog to digital converters (ADCs) comprised in the integrated circuit 64. In an embodiment the electronics unit 68 is configured to transfer signals from the integrated circuit 64. For example, in an embodiment the electronics unit 68 is configured to transfer signals indicative of currents of signal particles emitted from the sample 208 and detected at the substrate 61.

In an embodiment, as depicted in Figures 7 and 8, a conductive path may comprise one or more TSVs 65. Each TSV passes through the substrate 61 from an upbeam side of the substrate 61 to a downbeam side of the substrate 61. The TSVs allow electrical connections to be made between one side of the substrate 61 and the other side of the substrate 61.

In an embodiment the charged particle-optical element 60 may be the most downbeam charged particle-optical element of a charged particle-optical device 40. There may be only a small gap downbeam of the charged particle-optical component 60 to the sample 208. Alternatively, there may be only a small gap downbeam of the charged particle-optical element 60 to the next component of the charged particle-optical device 40. The upbeam side of the substrate 61 may therefore be more accessible than the downbeam side of the substrate 61. The TSVs 65 bring electrical contacts from the downbeam side to the more accessible upbeam side of the substrate 61.

In an embodiment, as depicted in Figures 7 and 8, a conductive path may comprise one or more conductive tracks in a layer 69 extending parallel to the plane of the substrate 61. The layer 69 may comprise a coating on the substrate 61 or on a layer (e.g., an insulating layer) formed on the substrate 61. Conductive paths in the layer 69 may be defined by applying a patterning process to a metallic layer to selectively remove parts of the metallic layer. Plural patterned metallic sub-layers separated from each other by insulating sub-layers may be formed to provide more complex wiring arrangements. Conductive tracks in different sub-layers may be selectively connected to each other by appropriately positioned metallic vias. Thus, the layer 69 may comprise a sub-layer or plurality of sub-layers containing conductive tracks configured to distribute electrical signals or power laterally. The layer 69 may be referred to as a redistribution layer.

In the example of Figure 7, a layer 69 containing conductive tracks is provided on the same side of the substrate 61 as the integrated circuit 64 (i.e., below the substrate 61 in the orientation depicted). The layer 69 extends from a region that at least laterally overlaps with the integrated circuit 64 to a region laterally outside of the integrated circuit 64, optionally laterally overlapping with the peripheral region 83 of the substrate 61. In the example of Figure 7, the layer 69 overlaps laterally with a position of the electronics unit 68 (e.g., PCB). One or more TSVs 65 provide electrical connections between the layer 69 and the electronics unit 68. In other embodiments, a further layer 69 may be provided on the side of the substrate 61 where the electronics unit 68 is located to allow electrical signals or power to be directed laterally towards appropriate electrical connection points of the electronics unit 68.

In the example of Figure 8, a layer 69 containing conductive tracks is provided on the side of the substrate 61 opposite to the integrated circuit 64 (i.e., above the substrate 61 in the orientation depicted). The layer 69 extends from a region that at least laterally overlaps with one or more TSVs 65 configured to provide direct or indirect electrical connections to the integrated circuit 64 through the substrate 61. In the example of Figure 8, a TSV 65 is shown that provides a connection directly from the integrated circuit 64 to the layer 69 above the substrate 61. In other embodiments, a layer 69 may redistribute signals or power laterally away from the integrated circuit 64 before connecting to one or more TSVs 65 to provide electrically connections through the substrate 61 to the layer 69 above the substrate 61.

In an embodiment the layer 69 is configured to transfer power and/or communication signals (e.g. control signals) between the electronics unit 68 and the integrated circuit 64. Conductive tracks in the layer 69 may be soldered or wire bonded, for example, to the electronics unit 68.

The view in Figure 9 is from the upbeam side of the substrate 61. The beam area 62 is circular in the example shown but may comprise any other shape, including square, rectangular, hexagonal, or any other regular or irregular polygon for example. In an embodiment, the charged particle-optical element 60 comprises one or more connector regions 75. A connector region 75 is a region in which a plurality of TSVs 65 are located. The TSVs may be arranged relatively close to each other within a connector region 75. In the example of Figure 9, the element 60 comprises three connector regions 75. In an embodiment the number of connector regions 75 is one, two, four or more than four. Each connector region 75 is connected by conductive tracks in a respective layer 69 to an electronics unit 68.

In an embodiment, as shown schematically in Figures 7-9, a cooling element 86 may be provided for cooling the substrate 61. In an embodiment, the cooling element 86 is mounted to the peripheral region 83 of the substrate 61. In the examples shown the cooling element 86 is mounted to an upbeam side of the substrate 61. The cooling element 86 is mounted in such a way as to have a high thermal conductance connection to the substrate 61. Having a high thermal conductance connection improves the efficiency with which heat can be conducted away from the substrate 61, thereby improving cooling performance. In an embodiment, the cooling element 86 is connected to the substrate 61 over a relatively large contact area. Providing a relatively large contact area promotes high thermal conductance. Arranging for the size of the substrate 64 to exceed the die-size of the lithographic imaging system used during manufacturing of the integrated circuit 64 as described above facilitates providing a large contact area. For example, in an embodiment the contact area is greater than 10%, optionally greater than 20%, optionally greater than 30%, optionally greater than 40%, optionally greater than 50%, of the die-size. In an embodiment, the cooling element 86 comprises a heat sink body (e.g., a block of material having a relatively high heat capacity and thermal conductivity). The heat sink body defines one or more internal channels 88 for directing flow of a heat-exchange fluid through the body. The increased space provided by arranging for the size of the substrate 64 to exceed the die-size facilitates configuring the cooling element 86 to have high performance. This may be achieved for example by increasing the size of the cooling element 86 to improve its function as a heat sink. Alternatively or additionally, the increased space may allow more effective internal channels 88 to be formed in the heat sink body, for example by configuring the cooling channels to provide a larger flow and/or increasing a surface area of contact between the heat-exchange fluid and walls of the internal channels 88. In an embodiment, a liquid management system may be provided for driving flow of the heat-exchange fluid through the one or more internal channels 88.

In an embodiment, as shown in Figure 9, a mechanical support element 84 may be provided for mechanically supporting the substrate 61. In the example of Figure 9, two of the mechanical support elements 85 are provided. Each mechanical support element 84 is configured to mechanically support the substrate 61 via the peripheral region 83 of the substrate 61. Each mechanical support element 84 may thus be mechanically connected to the substrate 61 partially or entirely in the peripheral region 83. Each mechanical support element 84 may be rigidly connected to the substrate 61, directly or indirectly. Each mechanical support element 84 may rigidly connect the substrate 61 to another element of the module 55 or to one or more elements outside of the module 55. The increased space provided by arranging for the size of the substrate 61 to exceed the die-size facilitates configuring each mechanical support element 84 to have high performance. Each mechanical support element 84 can, for example, contact the substrate 61 over a larger area, thereby spreading forces applied to the substrate 61 and reducing potentially damaging pressures and/or torques. Additionally, a large contact area may allow the mechanical support element 84 to contribute to improving cooling of the substrate 61 by providing a high thermal conductance path for heat to flow away from the substrate 61.

Arrangements of the present disclosure may be embodied in an assessment apparatus for assessing a sample 208 using charged particles. The assessment apparatus may take any of the forms described above with reference to Figure 1. The assessment apparatus may comprise a charged particle optical device 40. The charged particle-optical device may take any of the forms described above with reference to Figures 2-5. In an embodiment, the assessment apparatus comprises a sample support configured to support a sample 208. In an embodiment, the assessment apparatus comprises a charged particle-optical module 55 configured to direct charged particles along at least one beam path towards the sample 208. The charged-particle module 55 may take any of the forms described above, for example with reference to Figures 6-9.

In an embodiment, a chip assembly is provided. The chip assembly comprises a chip comprising an integrated circuit 64 formed in a semiconductor substrate 61. The substrate 61 may comprise an aperture 63 for passage of a beam path. The chip may thus take any of the forms described above with reference to Figures 7-9. Alternatively, the substrate 61 of the chip assembly may be provided without any apertures 63 for beam paths. The chip of the chip assembly may thus be applied in contexts other than as part of a charged particle-optical element. In this case, the chip may take any of the forms described above with reference to Figures 7-9 except for having the apertures 63. In an embodiment, the size of the substrate 61 exceeds a die-size of a lithographic imaging system used during manufacturing of the integrated circuit 64. As explained above, configuring the substrate 61 to have a size that exceeds a die-size of a lithographic imaging system used during manufacturing of the integrated circuit 64 may facilitate temperature control of the chip by providing more space in a peripheral region 83 of the substrate 61. In an embodiment, a cooling element is mounted to the peripheral region 83. The peripheral region 83 is laterally outside of an inner region 82 in which the integrated circuit 64 is formed. The cooling element 86 may comprise a heat sink and/or define one or more internal channels 88 for directing flow of a heat-exchange fluid. The cooling element 86 and/or internal channels 88 may take any of the forms described above with reference to Figures 7 and 8 or other forms. In an embodiment, a liquid management system is provided for driving flow of the heat-exchange fluid through the one or more internal channels 88. In an embodiment, the chip comprises one or more scribe lane structures located between the integrated circuit 64 and the peripheral region 83.

In an embodiment the charged particle-optical element 60 and/or charged particle-optical module 55 may be formed using microelectromechanical components (MEMS) manufacturing techniques and/or be referred to as MEMS elements. One or more of such elements may be controlled to be set at a high potential difference relative to a reference potential (e.g. ground) during use. Such elements may be electrically connected to one or more voltage supplies for supplying the voltages to the elements. In an embodiment a controller is configured to control the voltage applied to the elements.

Embodiments are provided according to the following numbered clauses:
Clause 1: A charged particle-optical element for a charged particle-optical module configured to direct charged particles along at least one beam path towards a sample, the charged particle-optical element comprising:
   a chip comprising an integrated circuit formed in a semiconductor substrate, the substrate defining at least one aperture for passage therethrough of the at least one beam path, wherein:
      a size of the substrate exceeds a die-size of a lithographic imaging system used during manufacturing of the integrated circuit.
Clause 2. The element of clause 1, wherein the integrated circuit is configured to detect signal particles emitted from the sample.
Clause 3. The element of clause 1 or 2, wherein the integrated circuit comprises: complementary metal oxide semiconductor, CMOS, circuitry; SiGe circuitry; and/or GaAs circuitry.
Clause 4. The element of any preceding clause, wherein:
   the substrate comprises an inner region and a peripheral region;
   the integrated circuit is formed within the inner region;
   the peripheral region is free of any functional integrated circuit; and
   the peripheral region is laterally outside of the inner region when viewed perpendicularly to a major surface of the substrate.
Clause 5. The element of clause 4, wherein an inner boundary of the peripheral region defines a region, when viewed perpendicularly to the major surface of the substrate, that is equal in size to the die-size of the lithographic imaging system used during manufacturing of the integrated circuit. Clause 6. The element of clause 4 or 5, configured to provide a plurality of electrically conductive paths from the peripheral region to the integrated circuit.
Clause 7. The element of clause 6, wherein one or more of the conductive paths comprises:
   one or more redistribution layers; and
   one or more through substrate vias, TSVs.
Clause 8. The element of any of clause 4 to 7, wherein the substrate comprises one or more scribe lane structures formed in a scribe lane located outside of the integrated circuit when viewed perpendicularly to the major surface of the substrate.
Clause 9. The element of clause 8, wherein the one or more scribe lane structures are located between the integrated circuit and at least a portion of the peripheral region when viewed perpendicularly to the major surface of the substrate.
Clause 10. The element of clause 8 or 9, wherein the one or more scribe lane structures comprise one or more alignment marks.
Clause 11. A charged particle-optical module comprising the element of any preceding clause, wherein the substrate comprises an inner region and a peripheral region, the integrated circuit is formed within the inner region, the peripheral region is free of any functional integrated circuit, and the peripheral region is laterally outside of the inner region when viewed perpendicularly to a major surface of the substate.
Clause 12. The module of clause 11, further comprising a cooling element mounted to the peripheral region and configured to extract heat from the substrate.
Clause 13. The module of clause 12, wherein the cooling element comprises a heat-sink body defining one or more internal channels for directing flow of a heat-exchange fluid through the body.
Clause 14. The module of clause 12 or 13, wherein a contact area between the cooling element and the substrate is greater than 10% of the die-size of a lithographic imaging system used during manufacturing of the integrated circuit.
Clause 15. The module of any of clauses 11 to 14, further comprising a mechanical support element configured to mechanically support the substrate, wherein the mechanical support element is configured to support the substrate via the peripheral region of the substrate.
Clause 16. An assessment apparatus for assessing a sample using charged particles, the apparatus comprising:
   a sample support configured to support a sample; and
   the module of any of clauses 11 to 15 configured to direct charged particles along at least one beam path towards the sample.
Clause 17. A chip assembly comprising:
   a chip comprising an integrated circuit formed in a semiconductor substrate, wherein a size of the substrate exceeds a die-size of a lithographic imaging system used during manufacturing of the integrated circuit; and
   a cooling element mounted to a peripheral region laterally outside of an inner region in which the integrated circuit is formed, wherein the cooling element comprises a heat sink body defining one or more internal channels for directing flow of a heat-exchange fluid through the body.
Clause 18. The chip assembly of clause 17, wherein the chip comprises one or more scribe lane structures formed in a scribe lane located outside of the integrated circuit when viewed perpendicularly to a major surface of the substrate.
Clause 19. A method of manufacturing a charged particle-optical element, comprising:
   manufacturing an integrated circuit within a die of a semiconductor wafer, a die-size of the die being defined by a lithographic imaging system used during the manufacturing of the integrated circuit;
   cutting a chip out of the wafer, wherein the chip comprises the integrated circuit formed in a substrate derived from the wafer;
   forming at least one aperture in the substrate for passage through the substrate of at least one beam path of a charged particle beam, wherein:
      a size of the substrate exceeds the die-size of the lithographic imaging system.

While the present invention has been described in connection with various embodiments, other embodiments of the invention will be apparent to those skilled in the art from consideration of the specification and practice of the invention disclosed herein. For example, as described above in an embodiment the substrate has portions of different thicknesses, with the electrical connector extending through the thinner portion. However, the thickness of the substrate may alternatively be uniform. The electrical connection for the electronic component may be further towards the periphery of the substrate than the electronic component and the electrically conductive layer may be electrically connected to the electrical connection. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the claims.

## Claims

1. A charged particle-optical element for a charged particle-optical module configured to direct charged particles along at least one beam path towards a sample, the charged particle-optical element comprising:
a chip comprising an integrated circuit formed in a semiconductor substrate, the substrate defining at least one aperture for passage therethrough of the at least one beam path, wherein:
a size of the substrate exceeds a die-size of a lithographic imaging system used during manufacturing of the integrated circuit.

2. The element of claim 1, wherein the integrated circuit is configured to detect signal particles emitted from the sample.

3. The element of claim 1 or 2, wherein the integrated circuit comprises: complementary metal oxide semiconductor, CMOS, circuitry; SiGe circuitry; and/or GaAs circuitry.

4. The element of claim 1, wherein:
the substrate comprises an inner region and a peripheral region;
the integrated circuit is formed within the inner region;
the peripheral region is free of any functional integrated circuit; and
the peripheral region is laterally outside of the inner region when viewed perpendicularly to a major surface of the substrate.

5. The element of claim 4, wherein an inner boundary of the peripheral region defines a region, when viewed perpendicularly to the major surface of the substrate, that is equal in size to the die-size of the lithographic imaging system used during manufacturing of the integrated circuit.

6. The element of claim 4, configured to provide a plurality of electrically conductive paths from the peripheral region to the integrated circuit.

7. The element of claim 6, wherein one or more of the conductive paths comprises:
one or more redistribution layers; and
one or more through substrate vias, TSVs.

8. The element of claim 4, wherein the substrate comprises one or more scribe lane structures formed in a scribe lane located outside of the integrated circuit when viewed perpendicularly to the major surface of the substrate.

9. The element of claim 8, wherein the one or more scribe lane structures are located between the integrated circuit and at least a portion of the peripheral region when viewed perpendicularly to the major surface of the substrate.

10. A charged particle-optical module comprising the element of any preceding claim, wherein the substrate comprises an inner region and a peripheral region, the integrated circuit is formed within the inner region, the peripheral region is free of any functional integrated circuit, and the peripheral region is laterally outside of the inner region when viewed perpendicularly to a major surface of the substate.

11. The module of claim 10, further comprising a cooling element mounted to the peripheral region and configured to extract heat from the substrate.

12. The module of claim 11, wherein a contact area between the cooling element and the substrate is greater than 10% of the die-size of a lithographic imaging system used during manufacturing of the integrated circuit.

13. The module of claim 10, further comprising a mechanical support element configured to mechanically support the substrate, wherein the mechanical support element is configured to support the substrate via the peripheral region of the substrate.

14. An assessment apparatus for assessing a sample using charged particles, the apparatus comprising:
a sample support configured to support a sample; and
the module of any of claims 10 to 13 configured to direct charged particles along at least one beam path towards the sample.

15. A chip assembly comprising:
a chip comprising an integrated circuit formed in a semiconductor substrate, wherein a size of the substrate exceeds a die-size of a lithographic imaging system used during manufacturing of the integrated circuit; and
a cooling element mounted to a peripheral region laterally outside of an inner region in which the integrated circuit is formed, wherein the cooling element comprises a heat sink body defining one or more internal channels for directing flow of a heat-exchange fluid through the body.
